Europäisches Patentamt

European Patent Office

Office européen des brevets

(11) Veröffentlichungsnummer: **0 295 324**
**A1**

## EUROPÄISCHE PATENTANMELDUNG

(21) Anmeldenummer: **87108827.4**

(22) Anmeldetag: **19.06.87**

(51) Int. Cl.⁴: **B01J 8/24 , B01J 8/44 ,**
**F23C 11/02 , F26B 3/08**

(43) Veröffentlichungstag der Anmeldung:
**21.12.88 Patentblatt 88/51**

(84) Benannte Vertragsstaaten:
**BE CH DE ES FR GB GR IT LI LU NL SE**

(71) Anmelder: **WAAGNER-BIRO**
**AKTIENGESELLSCHAFT**
**Stadlauer-Strasse 54 Postfach 11**
**A-1221 Wien(AT)**

(72) Erfinder: **Heger, Norbert, Dipl.-Ing.**
**Wehrgasse 11a/7**
**A-1050 Wien(AT)**
Erfinder: **Beckmann, Georg, Dipl.-Ing., Dr.**
**Jacquingasse 55/10**
**A-1030 Wien(AT)**

(74) Vertreter: **Wallner, Gerhard, Dipl.-Ing.**
**Waagner-Biro Aktiengesellschaft**
**Patentreferat Postfach 11**
**A-1221 Wien(AT)**

(54) **Wirbelschichtbehandlungseinrichtung.**

(57) Es wird ein Anströmboden 1 für eine Wirbelschichtbehandlungseinrichtung beschrieben, der Düsen 4 für das Fluidisierungsmedium aufweist. Die
Düsen 4 sind in Leisten 5 angeordnet, die in der
Verlängerung der Wärmetauschflächen vorgesehen
sind, so daß die Gassen 8 leicht entleerbar sind. Die
Düsen 4 sind praktisch nicht verlegbar, so daß eine
gleichmäßige Fluidisierung zwangsweise erreicht
wird. Dies bewirkt eine Reduktion der benötigten
Mengen an Fluidisierungsmedium und damit auch
eine Verminderung an Reinigungsleistung und Aufbereitung für das Fluidisierungsmedium.

Fig.1

# Wirbelschichtbehandlungseinrichtung

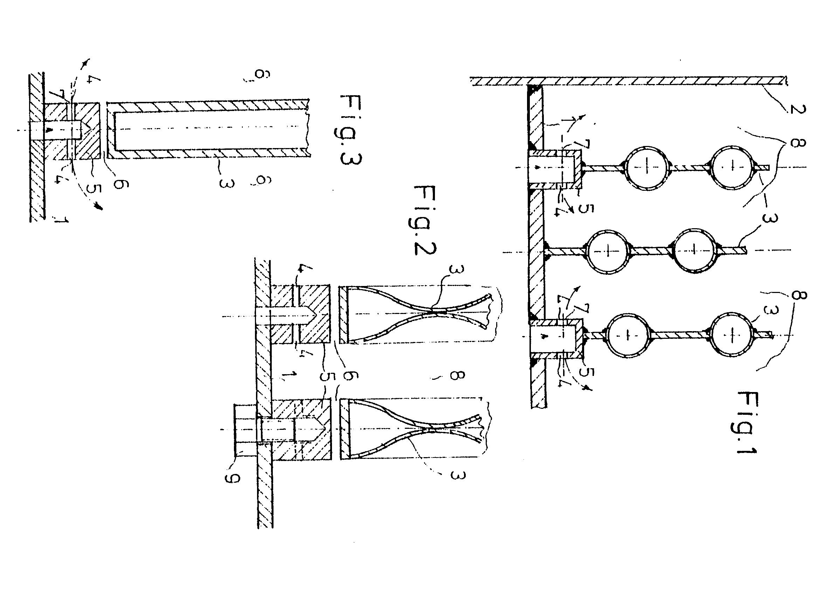

Die Erfindung betrifft eine Wirbelschichtbehandlungseinrichtung, wie z.B. Trockner, Vergaser, Wirbelbettfeuerung oder Kühler, mit in dem Wirbelbett angeordenten Wärmetauschflächen. Es ist bekannt, den Boden eines Wirbelbettes siebförmig auszubilden, so daß das Fluidisierungsmedium theoretisch gleichmäßig in das Wirbelbett aufsteigt, wobei Heiz- oder Kühlflächen vorgesehen sein können. Da das im Wirkbelbett zu behandelnde Gut unterschiedliche Korngrößen aufweist, setzen sich die nicht fluidisierbaren Bestandteile am Boden an und verkleben einen Teil des siebförmigen Bodens, wodurch es zu Ungleichmäßigkeiten in der Fluidisierung kommt. Dies bewirkt bei eingebauten Wärmetauschflächen und damit bei engen Gassen oft den Ausfall einer ganzen Gasse, wodurch die Leistung des Fließbettes abnimmt. Um diesen Nachteil zu beheben, wird die Menge des Fluidisierungsmediums erhöht. Die Erfindung hat es sich zur Aufgabe gestellt, diesen Nachteilen zu begegnen und durch Ausschaltung dieser Unzukömmlichkeiten die Wirtschaftlichkeit von Wirbelbettanlagen zu erhöhen und die Menge an benötigtem Fluidisierungsmedium durch Verringerung des Sicherheitszuschlages an die theoretisch notwendige Menge heranzubringen. Die Erfindung ist dadurch gekennzeichnet, daß in der Nähe des Bodens des Wirbelbettes un terhalb, insbesondere in der Flucht, der Wärmetauschflächen mindestens in jeder zweiten Reihe von Wärmetauschflächen Düsen angeordnet sind, die von unten, insbesondere gleichmäßig, durch den Boden angespeist sind und das Fluidisierungsmedium etwa in horizontaler Richtung in die durch die Wärmetauschflächen gebildeten Gassen des Wirbelbettes einblasen. Weitere wesentliche Merkmale sind in den Unteransprüchen 2 bis 5 angegeben. Die Erfindung ermöglicht die zwangsweise gleichmäßige Beaufschlagung des Querschnittes der Wirbelschichte mit dem Fluidisierungsmedium, wobei die gleichmäßige Fluidisierung bereits am Anströmboden beginnt. Ferner ermöglicht die Erfindung die vollständige Entleerung des Wirbelbettes durch frei zugängliche ausgeprägte Schüttgutgassen, ohne daß Behinderungen durch Düsenkörper auftreten. Die Erdindung vermeidet unterschiedlich und unvollkommen fluidisierte Räume in der Wirbelschicht, Kurzschlußströmung von Gasse zu Gasse, und unterschiedliche Gängigkeiten in den einzelnen Gassen, wobei die Randgängigkeit an die Mittengängigkeit angepaßt werden kann. In wirtschaftlicher Hinsicht vereinfacht sich die Bauart der Wärmetauschplatten, da die Oberkante der Düsenleisten waagrecht ist. Darüber hinaus ergibt sich durch die gleichmäßig zwangsweise Fluidisierung ein geringerer Bedarf an Fluidisierungsmedium, während der Sicherheitszuschlag zur theoretisch erforderlichen Mindestfluidisierungsmenge bedeutend verkleinert werden bzw. unterbleiben kann. Die Erfindung ist in den angeschlossenen Fig. 1 bis beispielsweise und schematisch dargestellt, wobei in den Fig. 1,2 und 3 jeweils ein Querschnitt durch das Wirbelbett mit den einzelnen Heizflächen und dem Düsenkörper dargestellt ist.

So zeigt

Fig. 1 ein Wirbelbett, bei dem das Fluidisierungsme dium durch T-förmige Düsen 4 in die zu fluidisierenden Gassen 8 eingebracht wird. Die Düsen 4 sind in Leisten 5 zusammengefaßt, an welchen die Heizflächen 3 angeschweißt sind. Das Fluidisierungsmedium tritt unterhalb des Bodens 1 in die Düse ein und verzweigt sich dann durch die etwa horizontal angeordneten Bohrungen der Düsen 4 in zwei Teilstränge, die in die einzelnen Gassen münden.

Fig. 2 unterscheidet sich von Fig. 1 neben der Bauart der einzelnen Wärmetauschflächen 3 auch durch den Spalt 6 zwischen den Heizflächen und den Leisten 5, in welchen die Düsen 4 angeordnet sind, so daß unterschiedliche Bewegungen der Bauteile 3 und 1 durchführbar sind, wie dies beispielsweise bei vibrierten Wirbelschichtbehandlungseinrichtungen der Fall ist. Die Leisten 5 können dabei durch Schrauben 9 am Boden 1 angeschraubt werden. Die Heizflächen 3 können auch von unverschweißten Einzelrohren gebildet sein.

Fig. 3 zeigt eine Konstruktionsvariante zur Fig. 2, bei der die Wärmetauschflächen 3 beispielsweise als Hohlplatten ausgebildet sind, durch die das Beheizungsmedium strömt .

In den Fig. 1 bis 3 sind nur beheizte Zwischenwände dargestellt, wobei es selbstverständlich ist, daß bei Randgassen die Düsen 4 nur auf der zu fluidisierenden Seite angeordnet sind, so daß die Rinne nach außen dicht ist.

## Ansprüche

1) Wirbelschichtbehandlungseinrichtung, wie z.B. Trockner, Vergaser, Wirbelbettfeuerung oder Kühler, mit in dem Wirbelbett angeordenten Wärmetauschflächen, dadurch gekennzeichnet, daß in der Nähe des Bodens 1 des Wirbelbettes 2 unterhalb, insbesondere in der Flucht, der Wärmetauschflächen 3 mindestens in jeder zweiten Reihe von Wärmetauschflächen Düsen 4 angeordnet sind, die von unten, insbesondere gleichmäßig, durch den Boden 1 angespeist sind und das Fluidisierungsmedium etwa in horizontaler Richtung in die durch die Wärmetauschflächen 3 gebildeten Gassen 8 des Wirbelbettes 2 einblasen.

2) Wirbelschichtbehandlungseinrichtung nach Anspruch 1, dadurch gekennzeichnet, daß die Düsen 4 in Leisten 5 angeordnet sind, an welche sich nach oben die Heizflächen 3 mit spaltförmigem Zwischenraum 6 anschließen (Fig.2,3).

3) Wirbelschichtbehandlungseinrichtung nach Anspruch 1, dadurch gekennzeichnet, daß die Düsen 4 in Leisten 5 angeordnet sind, an welchen die Heizflächen 3 angeschweißt sind (Fig.1).

4) Wirbelschichtbehandlungseinrichtung nach Anspruch 2 oder 3, dadurch gekennzeichnet, daß die Leisten 5 mit dem Boden 1 durch Schrauben 9 verbunden sind.

5) Wirbelschichtbehandlungseinrichtung nach Anspruch 1, dadurch gekennzeichnet, daß die Düsen T-förmig durchbohrt sind und jeweils auf gegenüberliegenden Seiten Öffnungen 7 aufweisen, die in benachbarte Gassen 8 münden.

Fig.1

Fig.2

Fig.3

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | EP-A-0 179 996 (C. SCHMIDT)<br>* Auszug; Seite 3, Zeilen 21-23; Seite 4, Zeile 21 - Seite 5, Zeile 33; Figuren 1,2 *<br>--- | 1,5 | B 01 J 8/24<br>B 01 J 8/44<br>F 23 C 11/02<br>F 26 B 3/08 |
| A | EP-A-0 181 626 (ADEA STAL)<br>* Auszug; Seite 5, Zeilen 1-25; Figuren 1-3 *<br>--- | 1,2 | |
| A | FR-A-2 110 050 (CESKOSLOVENSKA AKADEMIE)<br>* Seite 1, Zeilen 1-5; Seite 6, Zeile 39 - Seite 7, Zeile 8; Figur 1 *<br>--- | 1,2 | |
| A | US-A-4 270 599 (J.M. CONNELL)<br>* Auszug; Figuren 1-4; Spalte 2, Zeile 34 - Spalte 4, Zeile 8; Spalte 5, Zeilen 3-10 *<br>--- | 1,3 | |
| A | NL-A-7 903 613 (KONINKLIJKE MACHINEFABRIEK STORK)<br>* Seite 1, Zeilen 1-5; Seite 4, Zeilen 18-35; Figuren 1,3 *<br>----- | 1,4 | **RECHERCHIERTE SACHGEBIETE (Int. Cl.4)**<br><br>B 01 J<br>F 22 B<br>F 23 C<br>F 26 B |

Der vorliegende Recherchenbericht wurde für alle Patentansprüche erstellt

| Recherchenort | Abschlußdatum der Recherche | Prüfer |
|---|---|---|
| DEN HAAG | 17-02-1988 | SIEM T.D. |